# EUROPÄISCHE PATENTSCHRIFT

(11) **EP 0 643 485 B1**
(45) Veröffentlichungstag und Bekanntmachung des Hinweises auf die Patenterteilung: **22.04.1998**
(21) Anmeldenummer: 94114230.9
(22) Anmeldetag: 09.09.1994
(51) Int. Cl.: H03K 17/082, H03K 17/16

(54) **Schaltungsanordnung zum sanften Abschalten eines FET-Halbleiterbauelementes bei Überstrom**
Circuit arrangement for soft switching off of a FET semiconductor device in case of overcurrent
Montage servant au blocage doux d'un dispositif semi-conducteur FET lors d'un surcourant

(30) Priorität: 09.09.1993 DE 4330624
(43) Veröffentlichungstag der Anmeldung: 15.03.1995
(73) Patentinhaber: SIEMENS AKTIENGESELLSCHAFT, 80333 München (DE)
(72) Erfinder: Konrad, Sven, Dipl.-Ing., D-15827 Blankenfelde (DE); Reinmuth, Klaus, Dipl.-Ing., D-81541 München (DE); Stut, Hans, Dipl.-Ing., D-82194 Gröbenzell (DE)

(56) Entgegenhaltungen:
- EP-A- 0 354 435
- EP-A- 0 467 682
- US-A- 3 969 637
- MACHINE DESIGN, Bd.5, Nr.62, 8. März 1990, CLEVELAND US Seiten 89 - 96 FRANK ET AL. 'Surviving short circuits'

## Beschreibung

Die Erfindung bezieht sich auf eine Schaltungsanordnung zum Abschalten eines durch Feldeffekt gesteuerten Halbleiterbauelementes bei Überstrom, mit einem zwischen dem Gateanschluß und dem Katodenanschluß liegenden Transistor, der durch ein Steuersignal leitend gesteuert wird, und einer Einrichtung, die bei Überstrom und gleichzeitig anliegendem Abschaltsignal die Steuerspannung des Transistors so einstellt, daß der Durchlaßwiderstand des Transistors erhöht wird.

Eine solche Schaltungsanordnung ist beispielsweise aus der EP-A-0 354 435 bekannt.

Eine solche Schaltungsanordnung ist allgemein gebräuchlich und für einen MOSFET z. B. in der DE 30 34 927 Al beschrieben worden. Der steuerbare Schalter entlädt die Gate-Source-Kapazität des Halbleiterbauelementes, wenn er leitend gesteuert wird und sperrt damit das Halbleiterbauelement.

Durch Feldeffekt gesteuerte Halbleiterbauelemente, also Leistungs-MOSFET und IGBT (Insulated Gate Bipolar Transistor), haben die Eigenschaft, daß ihre Abschaltzeit unabhängig vom abzuschaltenden Strom etwa gleich ist. D. h., daß die Abschaltsteilheit des Stroms bei Überstrom wesentlich höher ist als im normalen Betriebsfall. Daraus ergibt sich, daß die beim Abschalten bei Überstrom an Streuinduktivität im Laststromkreis erzeugten Überspannungen wesentlich höher sind als beim Abschalten bei Nennlast.

Der Erfindung liegt die Aufgabe zugrunde, eine Schaltungsanordnung der eingangs erwähnten Art so weiter zu bilden, daß das Abschalten bei Überstrom keine erhöhten Überspannungsspitzen erzeugt.

Diese Aufgabe wird gelöst durch eine Schaltungsanordnung nach Patentanspruch 1.

Weiterbildungen der Erfindung sind Gegenstand der Unteransprüche.

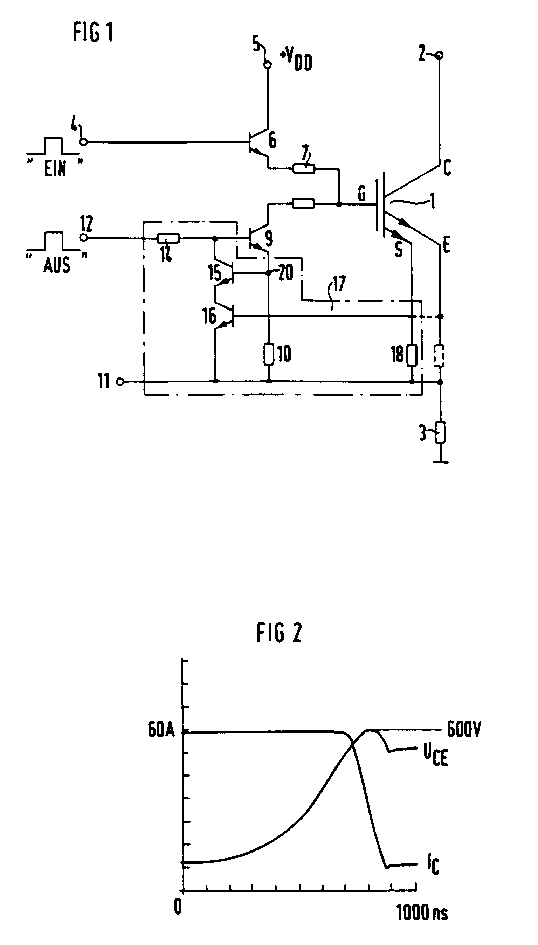

Die Erfindung wird anhand eines Ausführungsbeispiels in Verbindung mit den Figuren 1 und 2 näher läutert. Es zeigen
- Figur 1: eine Schaltungsanordnung gemäß Erfindung und
- Figur 2: den zeitlichen Strom- und Spannungsverlauf am Halbleiterbauelement 1 nach Figur 1.

Die Schaltungsanordnung nach Figur 1 enthält einen IGBT 1. Dieser IGBT ist mit seinem Kollektoranschluß C über einen Anschluß 2 mit einer Betriebsspannung verbunden. Mit seinem Emitteranschluß E liegt er über eine Last 3 an einem anderen Potential, z.B. an Masse. Der Gateanschluß G des IGBT 1 ist über einen Widerstand 7 und die Kollektor-Emitter-Strecke (Laststrecke) eines Bipolartransistors 6 mit einem Anschluß 5 verbunden, an dem eine Versorgungsspannung +V_{DD} liegt. Der Bipolartransistor 6 hat einen Basisanschluß, der mit einem Eingang 4 verbunden ist.

Der Gateanschluß des IGBT 1 ist über einen weiteren Widerstand und die Kollektor-Emitter-Strecke (Laststrecke) eines Transistors 9 mit einer Einrichtung 17 verbunden. Diese Einrichtung detektiert einerseits, ob ein Überstrom vorliegt und enthält andererseits einen Eingang, der über einen Widerstand 14 mit einem Eingang 12 verbunden ist.

Zum Einschalten des IGBT wird an den Eingang 4 ein Eingangssignal "Ein" angelegt. Damit wird der Bipolartransistor 6 leitend und die Gate-Source-Kapazität des IGBT 1 wird aufgeladen. Dieser wird damit leitend gesteuert.

Soll der IGBT aus dem normalen Betriebszustand, in dem Nennstrom fließt, abgeschaltet werden, so wird ein externes "AUS"-Signal an den Eingang 12 angelegt. Dieses steuert den Transistors 9 leitend und die Gate-Emitter-Kapazität des IGBT wird nach Maßgabe des Durchlaßwiderstandes des Transistors 9 und der im Entladestromweg liegenden Widerstände entladen.

Wird der IGBT 1 jedoch bei Überstrom durch ein externes "Aus"-Signal am Eingang 12 abgeschaltet, so sorgt die Einrichtung 17 dafür, daß der Transistor 9 nicht voll leitend gesteuert wird, sondern dafür, daß sein Arbeitspunkt in ein Bereich hohen Durchlaßwiderstandes verlegt wird..

Die Einrichtung 17 enthält einen ersten Bipolartransistor 15 und einen zweiten Bipolartransistor 16. Die Kollektor-Emitter-Strecken beider Transistoren sind in Reihe geschaltet.

Der Kollektoranschluß des ersten Bipolartransistors 15 ist mit dem Basisanschluß des Transistors 9 und der Emitteranschluß des zweiten Bipolartransistors 16 ist mit einem gemeinsamen Anschluß 11 verbunden. Außerdem ist der Basisanschluß von 9 über einen Widerstand 14 mit dem Eingang 12 verbunden. Die Einrichtung 17 enthält einen Widerstand 10, der einerseits mit dem gemeinsamen Anschluß 11 und andererseits mit dem Emitteranschluß des Transistors 9 verbunden ist. Der Knoten 20 zwischen Transistor 9 und Widerstand 10 ist mit dem Basisanschluß des ersten Bipolartransistors 15 verbunden, der Basisanschluß des zweiten Bipolartransistors 16 alternativ entweder mit dem Emitteranschluß E des IGBT 1 oder mit einem sogenannten "Sense"-Anschluß S. Leistungs-MOSFET mit diesem Anschluß sind z.B. in der Zeitschrift "Machine Design", 8. März 1990, S. 89-96 beschrieben, IGBT z.B. in "elektronik industrie", 1-1991, S. 14-18. Für den Fall, daß der Basisanschluß von 16 mit dem Anschluß S verbunden ist, ist zwischen S und dem gemeinsamen Anschluß 11 ein Meßwiderstand 18 angeschlossen. Gemäß der erwähnten Alternative liegt der Meßwiderstand direkt im Weg des Laststroms des IGBT zwischen seinem Emitteranschluß E und der Last 3. Er ist in diesem Fall entsprechend dem Stromverhältnis um den Faktor I_{S}/I_{E} kleiner dimensioniert.

Der Meßwiderstand 18 und die Einrichtung 17 ist so bemessen, daß der Bipolartransistor 16 bei Überstrom leitend gesteuert wird. Bei gleichzeitigem Anliegen eines Ausschaltsignals am Eingang 12 fließt dann ein Strom durch den Transistor 9, die Basis-Emitter-Strecke des Transistors 15 und die Kollektor-Emitter-Strecke des Emitters 16. Am Knoten 20 und damit am Emitter des Transistors 9 liegt jetzt eine Spannung an, die der Summe aus Basis-Emitterspannung von 15 und der Durchlaßspannung von 16 entspricht, z.B. 1V. Da die Transistoren 15, 16 beide leitend gesteuert sind, liegt am Basisanschluß des Transistors 9 eine Spannung an, die durch das Spannungsteilerverhältnis des Widerstandes 14 einerseits und der Summe der Spannungsabfälle der Transistoren 15 und 16 andererseits bestimmt ist. Dies wird derartig eingestellt, daß der Transistor 9 wie erwähnt in einen Bereich mit verglichen mit dem voll leitenden Zustand höherem Widerstand gesteuert wird. Die Entladung der Gate-Sourcekapazität des IGBT 1 geschieht damit langsamer und entsprechend langsamer wird der Strom durch den IGBT abnehmen. Vorzugsweise ist die Einrichtung derart dimensioniert, daß der Bipolartransistor 9 im wesentlichen waagrechten Teil seiner I_{C}/U_{CE}-Kennlinie arbeitet. Hier ist der Strom im wesentlichen von der Kollektor-Emitterspannung unabhängig (Stromquelle), so daß der Entladestrom spannungsunabhängig ist.

In Figur 2 ist der Verlauf der Spannung U_{CE} bzw. des Stroms I_{C} über der Zeitachse aufgetragen. Hieraus ist ersichtlich, daß bei einer Fallzeit des Stromes von 200ns keine schädliche Überspannung auftritt. Beim Abschalten aus dem Normalzustand ist die Stromabnahme über der Zeit -di/dt kleiner als beim Abschalten aus dem Überstromfall. Daher kann der IGBT in diesem Fall schneller abgeschaltet werden, ohne daß schädliche Überspannungen auftreten.

Die Erfindung wurde in Verbindung mit einem IGBT beschrieben. Sie kann aber auch für einen Leistungs-MOSFET verwendet werden. Im Prinzip ist es auch möglich, den Bipolartransistor 9 durch einen MOSFET zu ersetzen.

Durch entsprechende Dimensionierung läßt sich erreichen, daß der Transistor 9 ebenfalls als Stromquelle wirkt.

## Patentansprüche

1. Schaltungsanordnung zum Abschalten eines durch Feldeffekt gesteuerten Halbleiterbauelements (1) bei Überstrom, mit einem Transistor (9), dessen Laststrecke zwischen dem Gateanschluß und dem Katodenanschluß des Halbleiterbauelements (1) liegt, wobei der Transistor (9) durch eine Steuerspannung leitend gesteuert wird, und mit einer Einrichtung (17), die bei Überstrom und gleichzeitig anliegendem Abschaltsignal die Steuerspannung des Transistors so einstellt, daß der Durchlaßwiderstand des Transistors ernöht wird,
**dadurch gekennzeichnet,**
daß der Laststrecke des Transistors (9) ein Widerstand (10) in Reihe geschaltet ist, daß der nicht mit dem Transistor (9) verbundene Anschluß des Widerstandes mit einem gemeinsamen Anschluß (11) verbunden ist, daß zwischen dem Steuereingang des Transistors und dem gemeinsamen Anschluß zwei bezüglich ihrer Laststrecken in Reihe geschaltete Bipolartransistoren (15, 16) angeschlossen sind, daß der Basisanschluß des ersten Bipolartransistors (15) mit dem Knoten zwischen Widerstand (10) und Transistor (9) verbunden ist, daß der zweite Bipolartransistor (16) über seinen Basisanschluß bei Überstrom leitend gesteuert wird, und daß der Steuereingang des Transistors (9) über einen Widerstand (14) mit dem Anschluß (12) verbunden ist, an dem das Abschaltsignal anliegt.

2. Schaltungsanordnung nach Anspruch 1,
**dadurch gekennzeichnet**, daß der Basisanschluß des zweiten Bipolartransistors (16) zwischen dem Katodenanschluß und einem im Stromweg des durch Feldeffekt gesteuerten Halbleiterbauelementes (1) liegenden Widerstandes (18) angeschlossen ist.

3. Schaltungsanordnung nach Anspruch 2,
**dadurch gekennzeichnet**, daß das durch Feldeffekt gesteuerte Halbleiterbauelement (1) einen "Sense"-Anschluß (S) hat und daß der Widerstand (18) an den "Sense"-Anschluß angeschlossen ist.

## Claims

1. Circuit arrangement for turning off a field effect-controlled semiconductor component (1) in the event of overcurrent, having a transistor (9) whose load path is connected between the gate terminal and the cathode terminal of the semiconductor component (1), the transistor (9) being switched on by a control voltage, and having a device (17) which, in the event of overcurrent and the simultaneous presence of a turn-off signal, sets the control voltage of the transistor in such a way that the forward resistance of the transistor is increased,
characterized in that a resistor (10) is connected in series with the load path of the transistor (9), in that the resistor terminal which is not connected to the transistor (9) is connected to a common terminal (11), in that two bipolar transistors (15, 16) which are connected in series with regard to their load paths are connected between the control input of the transistor and the common terminal, in that the base terminal of the first bipolar transistor (15) is connected to the node between resistor (10) and transistor (9), in that the second bipolar transistor (16) is switched on via its base terminal in the event of overcurrent, and in that the control input of the transistor (9) is connected via a resistor (14) to the terminal (12) at which the turn-off signal is present.

2. Circuit arrangement according to Claim 1, characterized in that the base terminal of the second bipolar transistor (16) is connected between the cathode terminal and a resistor (18) which is connected in the current path of the field effect-controlled semiconductor component (1).

3. Circuit arrangement according to Claim 2, characterized in that the field effect-controlled semiconductor component (1) has a "sense" terminal (S), and in that the resistor (18) is connected to the "sense" terminal.

## Revendications

1. Montage servant au blocage d'un dispositif semi-conducteur (1) contrôlé par effet de champ lors d'un surcourant, comprenant un transistor (9) dont le trajet de charge est situé entre la borne de la grille et la borne de la cathode du dispositif semi-conducteur (1), le transistor (9) étant commandé par une tension de commande pour passer à l'état conducteur, et comprenant un dispositif (17) qui, en présence d'un surcourant et d'un signal de blocage appliqué simultanément, règle la tension de commande du transistor de manière à ce que la résistance à l'état passant du transistor soit plus élevée, caractérisé en ce qu'une résistance (10) est montée en série avec le trajet de charge du transistor (9), en ce que la borne de la résistance qui n'est pas reliée au transistor (9) est reliée à une borne commune (11), en ce que deux transistors bipolaires (15, 16) dont les trajets de charge sont branchés en série sont montés entre l'entrée de commande du transistor et la borne commune, en ce que la borne de base du premier transistor bipolaire (15) est reliée au noeud situé entre la résistance (10) et le transistor (9), en ce que le second transistor bipolaire (16) est commandé, par le biais de sa borne de base, pour passer dans l'état conducteur lors d'un surcourant, et en ce que l'entrée de commande du transistor (9) est reliée, par le biais d'une résistance (14), à la borne (12) au niveau de laquelle est appliqué le signal de blocage.

2. Montage selon la revendication 1, caractérisé en ce que la borne de base du second transistor bipolaire (16) est branchée entre la borne de la cathode et une résistance (18) située sur le trajet du courant du dispositif semi-conducteur (1) contrôlé par effet de champ.

3. Montage selon la revendication 2, caractérisé en ce que le dispositif semi-conducteur (1) contrôlé par effet de champ possède une borne "de détection" (S) et en ce que la résistance (18) est reliée à la borne "de détection".
